(19) Europäisches Patentamt
European Patent Office
Office européen des brevets

(11) Publication number: **0 108 961**
**B1**

(12) # EUROPEAN PATENT SPECIFICATION

(45) Date of publication of patent specification: **14.01.87**

(51) Int. Cl.[4]: **H 01 L 29/10,** H 01 L 29/08, H 01 L 29/743

(21) Application number: **83110486.4**

(22) Date of filing: **20.10.83**

(54) **Thyristor device protected from an overvoltage.**

(30) Priority: **15.11.82 JP 199963/82**
**23.03.83 JP 48139/83**

(43) Date of publication of application:
**23.05.84 Bulletin 84/21**

(45) Publication of the grant of the patent:
**14.01.87 Bulletin 87/03**

(84) Designated Contracting States:
**CH DE LI SE**

(56) References cited:
**EP-A-0 062 099**
**EP-A-0 062 100**
**DE-A-2 738 152**
**US-A-4 060 825**
**US-A-4 314 266**

**IEDM INTERNATIONAL ELECTRON DEVICES MEETING, Washington, D.C., 7th-9th December 1981, pages 410-413, Technical Digest, New York, USA, J. X. PRZYBYSZ et al: "Thyristors with overvoltage self-protection"**

(73) Proprietor: **Kabushiki Kaisha Toshiba**
**72, Horikawa-cho Saiwai-ku**
**Kawasaki-shi Kanagawa-ken 210 (JP)**

(72) Inventor: **Ohashi, Hiromichi**
**3-2-3-204, Azamino**
**Midori-ku Yokohama-shi (JP)**
Inventor: **Yamaguchi, Yoshihiro**
**5-7-5, Tsuji**
**Urawa-shi Saitama-ken (JP)**

(74) Representative: **Henkel, Feiler, Hänzel & Partner**
**Möhlstrasse 37**
**D-8000 München 80 (DE)**

**EP 0 108 961 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

This invention relates to a thyristor device which is protected from an overvoltage.

When a voltage exceeding a breakover voltage (VBD) an overvoltage is applied between the anode and cathode of a thyristor, the thyristor device is broken by such minute breakover currents as several to scores of mA. To prevent a thyristor device from being broken by a mistaken ignition resulting from the application of an overvoltage a rated voltage 2 to 3 times higher than a source voltage is applied to a thyristor device. With a device such as a D.C. transmission thyristor value constructed by connecting many thyristors in series, some of the thyristors which have failed to be rendered conducting are undesirably impressed with an overvoltage several times higher than the rated voltage. In such a case, it is impossible to prevent a thyristor device from being broken by an overvoltage. From the above, there is a pressing need to develop a thyristor device protected from an overvoltage and the resulting breakage.

An example of a thyristor device protected from an overvoltage is set forth in V.A.K. Temple "Controlled Thyristor Turn-on For High di/dt Capability", IEDM, 1981, pp 406 to 409. This thyristor device consists of a main thyristor and pilot thyristor. Further proposed are a thyristor device using a thinned N base to control the VBD location, and a thyristor device utilizing curvature effects. When an overvoltage is applied in the forward direction between the anode and cathode of the main thyristor, an electric field is concentrated on the VBD location, causing a breakover. The resultant breakover current acts as the gate current of a pilot thyristor, rendering the pilot thyristor conducting. The conduction of the pilot thyristor enable the main thyristor to be safely triggered. However, the above-mentioned type of thyristor device has the drawback that the breakover current is concentrated on the narrow curved section of the thyristor device, probably breaking it before its main thyristor is fully rendered conducting. Consequently difficulties were encountered in developing a thyristor device which could be triggered with a high di/dt capability (critical rate of rise of on-state current).

From document EP—A—0 062 099 a thyristor device is known which comprises a main thyristor region and an auxiliary thyristor region. The di/dt capability of this thyristor device is increased by adjusting the dimensions of an auxiliary cathode emitter layer to extend deeper into a cathode base layer as compared to a main cathode emitter layer.

Further, document DE—A—2 738 152 discloses another thyristor device in which a control electrode region has a longer carrier life time than any other region so that when an overvoltage is supplied in forward direction first a current flows in this control electrode region to ignite a control thyristor region.

It is accordingly the object of this invention to provide a thyristor device protected from an overvoltage which has a high di/dt capability even when impressed with an overvoltage.

To attain the above mentioned object this invention provides a thyristor device protected from an overvoltage which comprises a P type emitter layer, an N type base layer formed on said P type emitter layer to define a first PN junction, a P type base layer formed on said N type base layer to define a second PN junction, said second PN junction comprising a breakover region having a lower breakover voltage than any other region, a first N type emitter layer formed on said P type base layer to define a third PN junction, said P type emitter layer, N type base layer and first N type emitter layer jointly constituting a main thyristor, a second N type emitter layer formed on said P type base layer to define a fourth PN junction, said P type emitter layer, N type base layer, P type base layer anf second N type emitter layer collectively constituting a pilot thyristor, said pilot thyristor being rendered conductive by a breakover current produced in the breakover region, an anode electrode formed on the surface of said P type emitter layer, a cathode electrode formed on the surface of said first N type emitter layer, and an auxiliary electrode formed on the surface of said second N type emitter layer, wherein the distance between said fourth PN junction and second PN junction is chosen to be shorter than the distance between said third PN junction and second PN junction, causing the crosswise resistance of said P type base layer underlying both the auxiliary electrode of the pilot thyristor and second N type emitter layer to be higher than that of said main thyristor, and wherein the second N type emitter layer extends deeper into the P type base layer than the first N type emitter layer, said thyristor device being characterized in that a minimum trigger current for said pilot thyristor is selected so as to be smaller than half a maximum breakover current allowed for said breakover region.

This invention offers the following advantages: a pilot thyristor can be easily triggered by a minute breakover current produced by impression of an overvoltage, thereby assuring a high di/dt capability; and the thyristor can be provided with overvoltage-suppressing means without damaging the main properties of the thyristor such as its on-state voltage.

Other objects and advantages will be apparent from the following description taken in conjunction with the accompanying drawings in which:

Fig. 1 is a cross sectional view of a thyristor device according to a first embodiment of this invention;

Fig. 2 graphically shows the relationship between a trigger current IGT supplied to a thyristor device protected from an overvoltage and the di/dt capability; and

Figs. 3 to 5 are cross sectional views of thyristor devices according to other embodiments of the invention.

A thyristor device protected from an overvoltage according to a first embodiment of this invention will now be described with reference to Fig. 1. The thyristor device comprises a P type emitter layer 11, an N type base layer 12, a P type base layer 13, an N type emitter layer 14, and an N type auxiliary emitter layer 17. The P type emitter layer 11 and N type base layer 12 form a first PN junction. The N type base layer 12 and P type base layer 13 constitute a second PN junction. The P type base layer 13 and N type emitter layer 14 constitute a third PN junction. The P type base layer 13 and N type auxiliary emitter layer 17 form a fourth PN junction. An anode electrode 15 is mounted on the P type emitter layer 11, and a cathode electrode 16 is deposited on the N type emitter layer 14. The N type emitter layer 14, P type base layer 13 and cathode electrode 16 provide a shorted emitter structure. An auxiliary electrode 18 is formed on the N type auxiliary emitter layer 17. The N type auxiliary emitter layer 17, P type base layer 13 and auxiliary electrode 18 constitue a shorted emitter structure. The P type emitter layer 11, N type base layer 12, P type base layer 13 and N type emitter layer 14 form a main thyristor MT. The P type emitter layer 11, N type base layer 12, P type base layer 13 and N type auxiliary emitter layer 17 constitute a pilot thyristor PT. The N type auxiliary emitter layer 17 of the pilot thyristor PT has a greater depth than the N type emitter layer 14 of the main thyristor MT. Therefore, the P type base layer 13 of the pilot thyristor PT is chosen to have a higher crosswise resistance than the P type base layer 13 of the main thyristor MT. The pilot thyristor PT is formed in the inner peripheral wall of the main thyristor MT. A P type base layer 30 comprising a curved section 19 is provided on the inner peripheral wall of the pilot thyristor PT.

The P type base layer 30 is fabricated, for example, by etching the P type base layer 13 in the form of a well and later thermally defusing a P type impurity from the surface, or by etching an N type semiconductor wafer in the form of a well and diffusing the P type impurity from both sides of said N type semiconductor wafer.

When an overvoltage is applied in the forward direction between the anode and cathode electrodes of the aforementioned structure, an electric field is concentrated on the curved section 19, causing a breakover current to be produced in the proximity of said curved section 19. The pilot thyristor PT is rendered conducting by said breakover current, followed by the conduction of the main thyristor MT. In the foregoing embodiment, a minimum trigger current IGT for the pilot thyristor PT which is first rendered conducting is smaller than at least half a maximum allowable breakover current produced in the breakover region provided in the curved section 19. To provide the above-mentioned minimum trigger current IGT, it is advisable to increase the crosswise resistance of the pilot thyristor PT to fully elevate the gate sensitivity of the pilot thyristor PT. This process, described below in relation to Fig. 2 prominently, improves the di/dt capability when an overvoltage is impressed.

The experiments conducted with the present inventors prove that a pilot thyristor can be safely rendered conductive. The abscissa of Fig. 2 represents a breakover current IR produced when the pilot thyristor PT was triggered by an overvoltage. This breakover current IR is equal to the trigger current IGT of the pilot thyristor PT. The ordinate denotes the di/dt capabilities of the test samples corresponding to the breakover current IGT. Fig. 2 shows that the di/dt capability occurring at the impression of an overvoltage increases as the pilot thyristor attains higher sensitivity and consequently can be satisfactorily triggered by a small trigger current IGT. However, all the test samples comprising a pilot thyristor having a larger trigger current than 45 mA have the following drawback; the di/dt capability suddenly drops when the trigger current rises above 45 mA, thus making it impossible to completely trigger a thyristor device when an overvoltage occurs. The reason for the above-mentioned drawback is that when the trigger current IGT exceeds 45 mA, the breakover current of the curved section 19 of the test samples used in the experiment rises above an allowed level, causing said curved section 19 to be broken before the pilot thyristor PT is rendered conducting. Fig. 2 further indicates that unless the trigger current IGT is set at a level lower than half to the maximum level IR (max) (=45 mA) (hereinafter referred to as "a maximum of the breakover current IR (max)"), then the di/dt capability cannot be improved. As inferred from Fig. 2, therefore, a high sensitivity pilot thyristor meeting the condition of at least

$$IGT < \frac{1}{2} IR$$

(max) should be set near the current section 19 in order to produce a thyristor device which can be completely triggered even when an overvoltage occurs and retains a high di/dt capability.

The present inventors' experiments further prove that the maximum breakover current IR (max) increases substantially in proportion to the peripheral length of the curved section 19. If, however, the curved section 19 is chosen to have an unduly long peripheral extension, the following difficulty arises when a sharply rising voltage noise is supplied: the resultant increase in the di/dt capability conversely leads to a prominent decline in the dv/dt capability. The reason for this undesirable occurrence is that a displacement current arising in the curved section 19 increases in proportion to the square of the peripheral length of said curved section 19. Therefore, it is impossible to extend the peripheral length of the curved section 19 indefinitely. Consequently a thyristor device protected from an overvoltage which has a high di/dt capability should preferably be provided without sacrificing the main thyristor property such as a dv/dt capability by

surrounding the curved section 19 with a high sensitivity pilot thyristor which can be triggered by a small trigger current IGT. According to the present invention, a high sensitivity pilot thyristor device is constructed by rendering the width of the P type base layer 13 underlying the N type emitter layer 17 of the pilot thyristor PT smaller than that of the P type base layer 13 of the main thyristor MT. As a result, the P type base layer 13 of the pilot thyristor PT has an increased crosswise resistance, thereby elevating the trigger sensitivity of said pilot thyristor PT.

A 4 KV thyristor device with dv/dt≧1500 v/µs and di/dt≧ 250 A/µs could be produced by setting the diameter of the curved section 19 at 0.5 mm, that is, by choosing its peripheral length to be 1.57 mm in order to obtain a maximum breakover current Ir (max) ranging from 40 to 45 mA and controlling the resistance of the P type base layer of the pilot thyristor PT to about 2000 Ω/□ in order to decrease the trigger current IGT from 5 mA.

As described above, the present invention provides a thyristor device protected from an overvoltage with a substantially improved di/dt capability without sacrificing the main thyristor properties such as the dv/dt capability.

A thyristor device protected from an overvoltage according to a second embodiment of this invention will now be described with reference to Fig. 3. A P type emitter layer 11, N type base layer 12. P type base layer 13 and N type emitter layer 14 jointly constitute a main thyristor MT. An anode electrode 15 is mounted on the P type emitter layer 11; a cathode electrode 16 is deposited on the N type emitter layer 16; and a gate electrode 20 is set on the P type base layer 13. A pilot thyristor PT consisting of an auxiliary N type emitter layer 17 and auxiliary electrode 18 is provided between the gate electrode 20 and cathode electrode 16. Part of a second PN junction defined by the N type base layer 12 and P type base layer 13 is curved. The upper end of the curved portion 19 is exposed to that surface of the thyristor device on which the cathode electrode 16 is deposited. The base width $W_{PB}$ of that portion of the P type base layer 13 which lies immediately below the N type emitter layer 17 of the pilot thyristor PT is rendered narrower than that of the P type base layer 13 of the main thyristor MT. Therefore, the P type base layer 13 of the pilot thyristor PT is chosen to have a higher crosswise resistance $R_P$ than that of the main thyristor MT.

When an overvoltage is applied in the forward direction between the anode electrode 15 and cathode electrode 16, breakover appears at the curved section 19 of the PN junction of the P type base layer 13 an N type base layer 12. The resultant breakover current IR flows across the P type base layer 13 to the cathode electrode 16 through the short-circuit section 21 of the main thyristor MT. The breakover current IR causes a decline in the voltage impressed across the P type base layer 13 in a lateral direction. As a result, the N type emitter layer 17 of the pilot thyristor PT is biased in the forward direction. When the forward bias voltage is higher than the diffusion potential of a fourth PN junction defined by the N type emitter layer 17 and P type base layer 13, the influx of electrons from the N type emitter layer 17 suddenly increases and renders the pilot thyristor PT conducting. An output current from the conducted pilot thyristor PT acts as a gate current for the main thyristor MT, eventually conducting the main thyristor MT.

The gate sensitivity of the pilot thyristor PT is determined by the crosswise resistance $R_P$ of that portion of the P type base layer 13 which lies immediately below the pilot thyristor PT. In the embodiment of Fig. 3, the above-mentioned crosswise resistance $R_P$ is related to the sheet resistance $\rho_{SP}$ of the P type base layer 13 and the geometric pattern of the N type emitter layer 17. Now assuming that the characters d1 and d2 respectively represent the inner and outer diameters of the ring-shaped N type emitter layer 17, then the crosswise resistance $R_P$ is rendered proportional to $\rho_{SP}$ and ln (d2/d1). The gate sensitivity of the pilot thyristor PT is increasingly elevated, as the crosswise resistance $R_P$ increases, thus enabling the pilot thyristor PT to be triggered by a small breakover current. Actually, the pilot thyristor PT could be triggered by a smaller breakover current than 5 mA, under the following conditions.

| | |
|---|---|
| Sheet resistance of the P type base layer 13 of the main thyristor MT | 500 Ω/□ |
| Sheet resistance $\rho_{SP}$ just below the pilot thyristor PT | 3000 Ω/□ |
| Diameter d1 | 1.5 mmφ |
| Diameter d2 | 2.0 mmφ |

The above-mentioned breakover current of less than 5 mA accounts for less than 1/6 of a minimum breakover current used for the conventional thyristor having a sheet resistance $\rho_{SP}$=500 Ω/□. The minimum trigger current realized with the thyristor device embodying this invention accounts for less than half a maximum breakover current produced in the breakover region constituted by the curved section 19.

Since the pilot thyristor PT can be triggered by an extremely small breakover current, a thyristor device embodying this invention can preserve a high di/dt capability even when triggered by an overvoltage.

A thyristor device according to a third embodiment of this invention will now be described with reference to Fig. 4. A light-receiving section 22 to be supplied with a light trigger signal is formed inside the pilot thyristor of the subject thyristor device. The other parts of Fig. 4 are the same as those of the thyristor device of Fig. 3, description thereof is omitted. The light activated thyristor device of Fig. 4 has the same effect as that previously described.

A thyristor device according to a fourth embodiment of this invention will now be described with reference to Fig. 5. With this thyristor device, a semiconductor region constituting a pilot thyristor PT is selected with a longer carrier life time τ2 than the carrier life time τ1 of the other regions. The above-mentioned arrangement increases the coefficient by which an electron avalanche occurring in the semiconductor region of the pilot thyristor is multiplied. Therefore, the pilot thyristor PT has a lower breakover voltage than any other region of a thyristor device. With the thyristor device of Fig. 5 according to the fourth embodiment of this invention, too, a minimum trigger current is chosen to be smaller than half a maximum breakover current allowed for the pilot thyristor.

**Claims**

1. A thyristor device protected from an .overvoltage which comprises:

a P type emitter layer (11);

an N type base layer (12) formed on said P type emitter layer (11) to define a first PN junction;

a P type base layer (13) formed on said N type base layer (12) to define a second PN junction, said second PN junction comprising a breakover region (19) having a lower breakover voltage than any other region;

a first N type emitter layer (14) formed on said P type base layer (13) to define a third PN junction, said P type emitter layer (11), N type base layer (13) and first N type emitter layer (14) jointly constituting a main thyristor (MT);

a second N type emitter layer (17) formed on said P type base layer (13) to define a fourth PN junction, said P type emitter layer (11), N type base layer (12), P type base layer (13) and second N type emitter layer (17) collectively constituting a pilot thyristor (PT), said pilot thyristor (PT) being rendered conductive by a breakover current produced in the breakover region; an anode electrode (15) formed on the surface of said P type emitter layer (11), a cathode electrode (16) formed on the surface of said first N type emitter layer (14), and an auxiliary electrode (18) formed on the surface of said second N type emitter layer (17), wherein the distance between said fourth PN junction and second PN junction is chosen to be shorter than the distance between said third PN junction and second PN junction, causing the crosswise resistance (RP) of said P type base layer (13) underlying both the auxiliary electrode (18) of the pilot thyristor (PT) and second N type emitter layer (17) to be higher than that of said main thyristor (MT), and wherein the second N type emitter layer (17) extends deeper into the P type base layer (13) than the first N type emitter layer (14),

characterized in that a minimum trigger current for said pilot thyristor is selected so as to be smaller than half the maximum breakover current allowed for said breakover region.

2. The thyristor device according to claim 1, characterized in that said second PN junction is defined by letting part (20) of said P type base layer protrude into the N type base layer, and is partly provided with a curved portion (19).

3. The thyristor device according to claim 1 or 2, characterized in that the upper end of a curved portion of said second PN junction is exposed to that portion of the surface of the thyristor device on which a cathode electrode is formed.

4. The thyristor device according to anyone of claims 1 to 3, characterized in that said breakover region is supplied with a light trigger signal.

5. The thyristor device according to claim 1, characterized in that said breakover region comprises a gate electrode (20) supplied with an electric trigger signal.

6. The thyristor device according to claim 1, characterized in that said breakover region is chosen to have a longer carrier life time than that of any other region.

**Patentansprüche**

1. Thyristoranordnung mit Überspannungsschutz, umfassend

eine P-Typ-Emitterschicht (11),

eine auf der P-Typ-Emitterschicht (11) unter Festlegung eines ersten PN-Übergangs ausgebildete N-Typ-Basisschicht (12),

eine auf der N-Typ-Basisschicht (12) unter Festlegung eines zweiten PN-Übergangs ausgebildete P-Typ-Basisschicht (13), wobei der zweite PN-Übergang eine Kippzone (19) mit einer niedrigeren Kippspannung als in jeder anderen Zone aufweist,

eine auf der P-Typ-Basisschicht (13) unter Festlegung eines dritten PN-Übergangs ausgebildete erste N-Typ-Emitterschicht (14), wobei die P-Typ-Emitterschicht (11), die N-Type-Basisschicht (13) und die erste N-Typ-Emitterschicht (14) gemeinsam einen Hauptthyristor (MT) bilden,

eine auf der P-Typ-Basisschicht (14) unter Festlegung eines vierten PN-Übergangs ausgebildete zweite N-Typ-Emitterschicht (17), wobei die P-Typ-Emitterschicht (11), die N-Typ-Basisschicht (12), die P-Typ-Basisschicht (13) und die zweite N-Typ-Emitterschicht (17) gemeinsam einen Steuerthyristor (PT) bilden, welcher durch einen in der Kippzone erzeugten Kippstrom leitend machbar bzw. durchschaltbar ist;

eine auf der (Ober-)Fläche der P-Typ-Emitterschicht (11) ausgebildete Anodenelektrode (15), eine auf der (Ober-)Fläche der ersten N - Typ - Emitterschicht (14) ausgebildete Kathodenelektrode (16) und eine auf der (Ober-)Fläche der zweiten N-Typ-Emitterschicht (17) ausgebildete Hilfselektrode (18), wobei der Abstand zwischen dem vierten PN-Übergang und dem zweiten PN-Übergang kleiner gewählt ist als der Abstand zwischen dem dritten PN-Übergang und dem zweiten PN-Übergang, so daß der Querwiderstand (RP) der sowohl unter der Hilfselektrode (18) des Steuerthyristors (PT) als auch unter der zweiten N-Typ-Emitterschicht (17) liegenden P-Typ-Basisschicht (13) höher wird als derjenige des Hauptthyristors (MT), une wobei

sich die zweite N-Typ-Emitterschicht (17) tiefer als die erste N-Typ-Emitterschicht (14) in die P-Typ-Basisschicht (13) hinein erstreckt,

dadurch gekennzeichnet, daß ein Mindest-Triggerstrom für den Steuerthyristor so gewählt (eingestellt) ist, daß er kleiner ist als die Hälfte des für die Kippzone zulässigen maximalen Kippstroms.

2. Thyristoranordnung nach Anspruch 1, dadurch gekennzeichnet, daß der zweite PN-Übergang dadurch festgelegt, daß ein Teil (20) der P-Typ-Basisschicht in die N-Typ-Basisschicht hineinreicht, und teilweise mit einem gekrümmten Abschnitt (19) versehen ist.

3. Thyristoranordnung nach Anspruch 1 oder 2, dadurch gekennzeichnet, daß das obere Ende eines gekrümmten Abschnitts des zweiten PN-Übergangs an dem Teil der Fläche der Thyristoranordnung, auf welchem eine Kathodenelektrode ausgebildet ist, (nach außen hin) freiliegt.

4. Thyristoranordnung nach einem der Ansprüche 1 bis 3, dadurch gekennzeichnet, daß die Kippzone mit einem Licht-Triggersignal speisbar ist.

5. Thyristoranordnung nach Anspruch 1, dadurch gekennzeichnet, daß die Kippzone eine mit einem elektrischen Triggersignal speisbare Gate-Elektrode (20) aufweist.

6. Thyristoranordnung nach Anspruch 1, dadurch gekennzeichnet, daß die Kippzone mit einer längeren Trägerlebensdauer als derjenigen jeder anderen Zone ausgelegt ist.

**Revendications**

1. Un dispositif à thyristor protégé contre la surtension, qui comporte:

une couche (11) d'émetteur du type P;

une couche (12) de base du type N qui est formée sur ladite couche (11) d'émetteur du type P pour définir une première jonction PN;

une couche (13) de base du type P qui est formée sur ladite couche (12) de base du type N pour définir une deuxième jonction PN, ladite deuxième jonction PN comportant une région de rupture (19) présentant une tension de rupture inférieure à celle de toute autre région;

une première couche (14) d'émetteur du type N qui est formée sur ladite couche (13) de base du type P pour définir une troisième jonction PN, lesdites couche (11) d'émetteur du type P, couche (13) de base du type N et première couche (14) d'émetteur du type N constituant conjointement un thyristor principal (MT);

une second couche (17) d'émetteur du type N qui est formée sur ladite couche (13) de base du type P pour définir une quatrième jonction PN, lesdites couche (11) d'émetteur du type P, couche (12) de base du type N, couche (13) de base du type P et seconde couche (17) d'émetteur du type N constituant collectivement un thyristor pilote (PT), ledit thyristor pilote (PT) étant rendu conducteur par un courant de rupture produite dans la région de rupture;

une électrode anode (15) formée sur la surface de ladite couche (11) d'émetteur du type P, une électrode cathode (16) formée sur la surface de ladite première couche (14) d'émetteur du type N, et une électrode auxiliaire (18) formée sur la surface de ladite seconde couche (17) d'émetteur du type N, la distance entre lesdites quatrième jonction PN et deuxième jonction PN étant choisie pour être plus faible que la distance entre lesdites troisième jonction PN et deuxième jonction PN, pour que la résistance en croix (RP) de ladite couche (13) de base du type P située sous l'électrode auxiliaire (18) du thyristor pilote PT et la seconde couche (17) d'émetteur du type N soit supérieure à celle dudit thyristor principal (MT), la seconde couche (17) d'émetteur du type N s'étendant plus en profondeur dans la couche (13) de base du type P que la première couche (14) d'émetteur du type N,

caractérisé en ce qu'un courant minimal de déclenchement pour ledit thyristor pilote est choisi de manière à être inférieur à la moitié du courant maximal de rupture permis pour ladite région de rupture.

2. Le dispositif à thyristor selon la revendication 1, caractérisé en ce que ladite deuxième jonction PN est définie en laissant dépasser une partie (20) de ladite couche de base du type P dans la couche de base du type N, et comporte partiellement une partie courbe (19).

3. Le dispositif à thyristor selon la revendication 1 ou 2, caractérisé en ce que l'extrémité supérieure d'une partie courbe de ladite deuxième jonction PN est exposée à la partie de la surface du dispositif à thyristor sur laquelle est formée l'électrode cathode.

4. Le dispositif à thyristor selon l'une quelconque des revendications 1 à 3, caractérisé en ce que ladite région de rupture reçoit un signal lumineux de déclenchement.

5. Le dispositif à thyristor selon la revendication 1, caractérisé en ce que ladite région de rupture comporte une électrode de porte (20) qui reçoit un signal électrique de déclenchement.

6. Le dispositif à thyristor selon la revendication 1, caractérisé en ce que ladite région de rupture est choisie pour présenter une durée de vie plus longue que celle de toute autre région.

FIG. 1

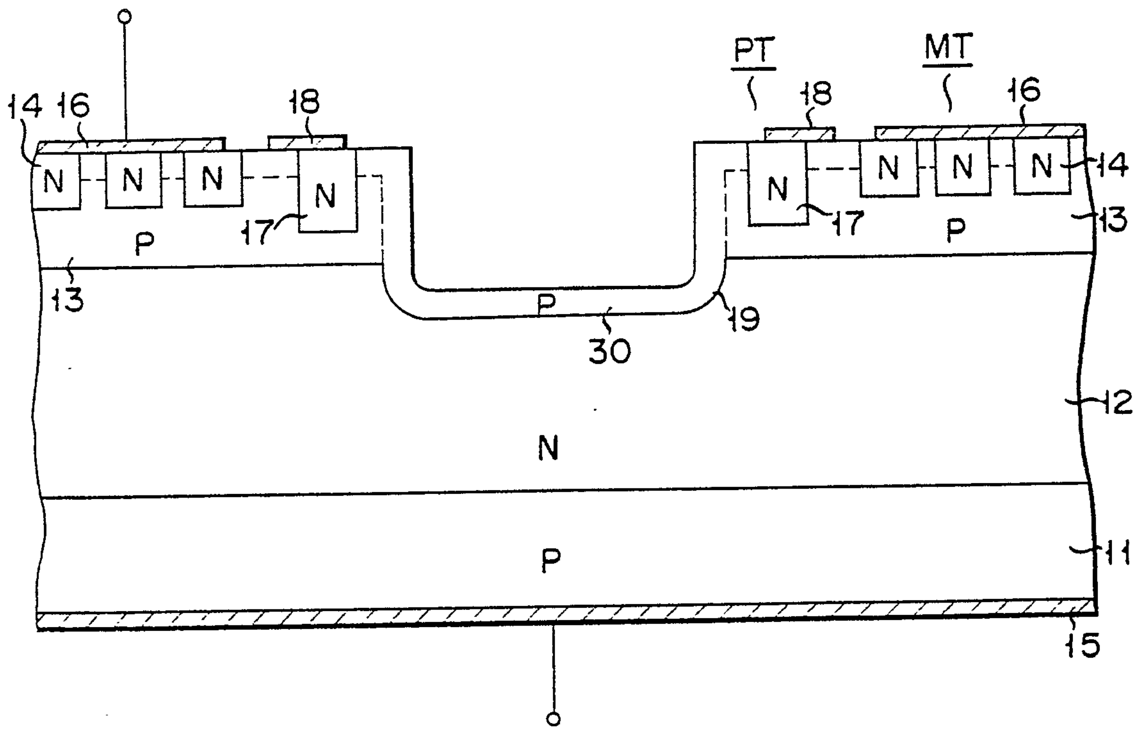
PT
MT
14
16
18
N
17
P
13
19
30
12
11
15

FIG. 2

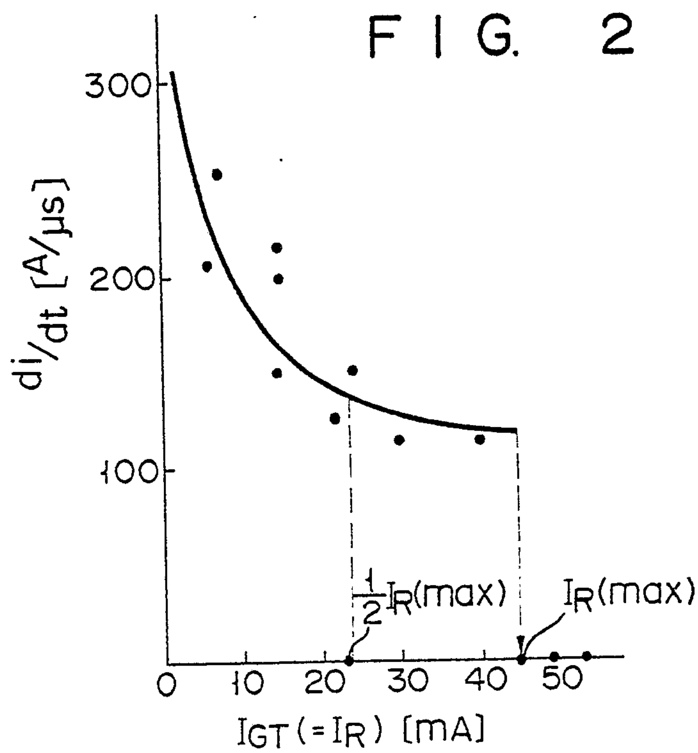
300
200
100
di/dt [A/µs]
0
10
20
30
40
50
$\frac{1}{2}$IR(max)
IR(max)
IGT (=IR) [mA]

FIG. 3

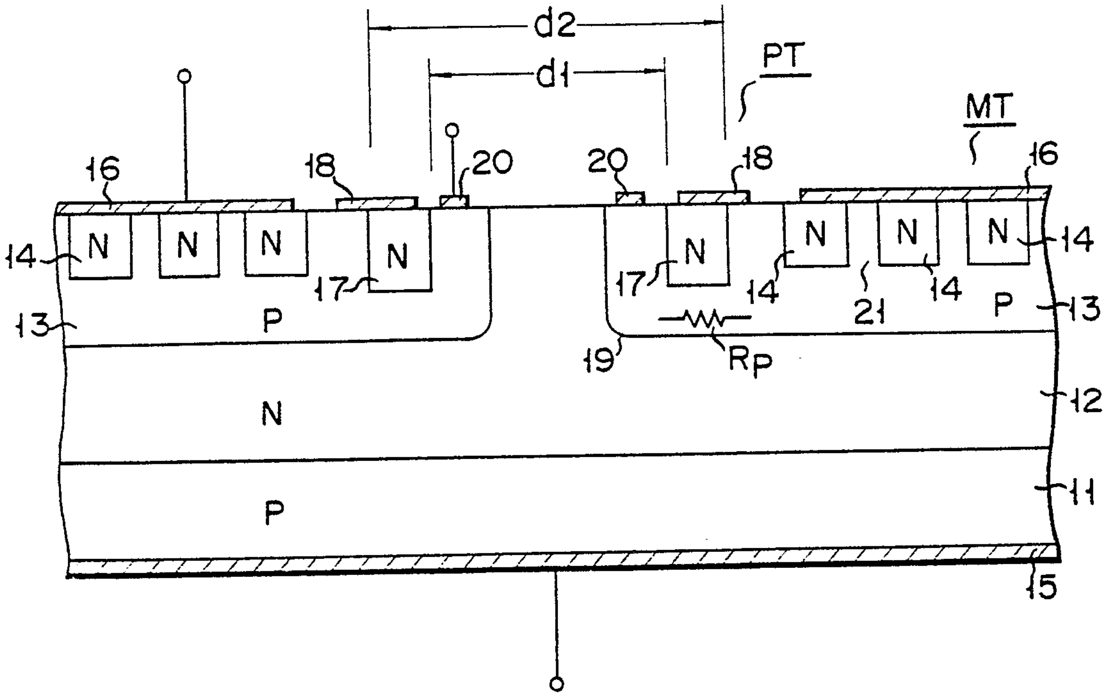
d2
d1
PT
MT
16
18
20
20
18
16
14
N
N
N
N
17
N
17
14
N
N
N
14
14
21
14
P
13
P
13
19
Rp
N
12
P
11
15

FIG. 4

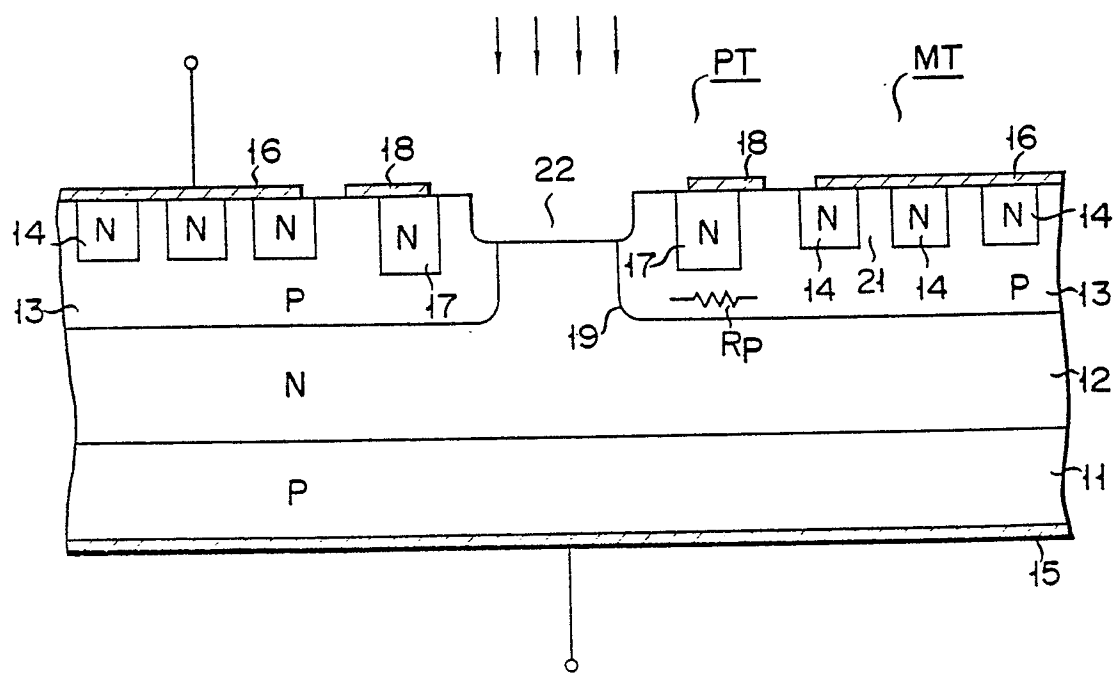
PT
MT
16
18
22
18
16
14
N
N
N
N
N
N
N
N
14
17
17
14
21
14
P
13
P
13
19
Rp
N
12
P
11
15

F I G. 5

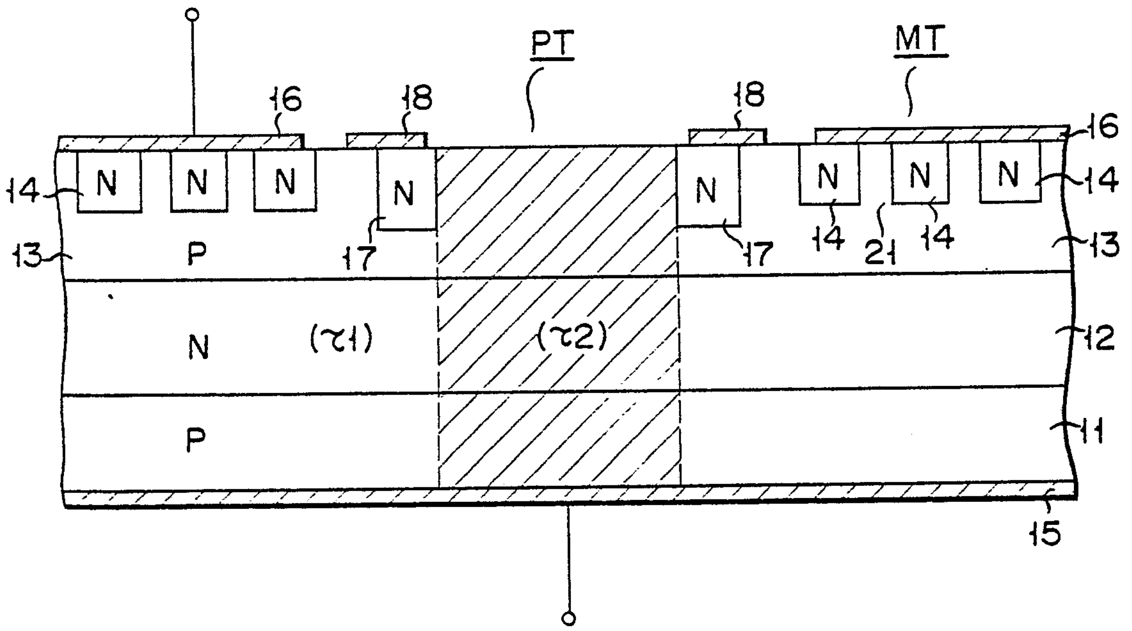
PT
MT
16
18
18
16
14
N
N
N
N
N
N
N
N
14
13
P
17
17
14
21
14
13
N
(τ1)
(τ2)
12
P
11
15